# EUROPEAN PATENT SPECIFICATION

(11) **EP 2 787 384 B1**
(45) Date of publication and mention of the grant of the patent: **08.03.2017**
(21) Application number: 13185930.8
(22) Date of filing: 25.09.2013
(51) Int. Cl.: G02B 26/02, G02B 26/08, G02F 1/1335, G09G 5/10, H01L 51/52

(54) **Display apparatus and image forming method**
Anzeigevorrichtung und Bilderzeugungsverfahren
Appareil d'affichage et procédé de formation d'image

(30) Priority: 01.04.2013 US 201313854161
(43) Date of publication of application: 08.10.2014
(73) Proprietor: HTC Corporation, Taoyuan City 330 (TW)
(72) Inventor: Lin, Yu-Wen, 330 Taoyuan City (TW); Tseng, Hsu-Hsiang, 330 Taoyuan City (TW); Shen, Weng-Chang, 330 Taoyuan City (TW)
(74) Representative: Ljungberg, Robert

(56) References cited:
- US-A1- 2007 216 987
- US-A1- 2007 279 558
- US-A1- 2011 235 147
- US-B1- 6 288 829

## Description

### BACKGROUND OF THE INVENTION

### 1. Field of the Disclosure

The disclosure generally relates to a display apparatus and an image forming method, and more particularly, to a display apparatus and an image forming method using a shutter unit to switch a background for the display.

### 2. Description of Related Art

Within the development of the display industry, transparent display panel has become a popular development topic. The transparent display panel is developed to display images without backlights, and the display panel may be a see-through display panel. Therefore, the display panel is also suitable and effective for augmented reality application. Based on the above-mentioned advantages, transparent display panel is commercially appealing.

Thin-Film Transistor Liquid Crystal Display (TFT-LCD) and Organic Light-Emitting Diode Display (OLED display) are two types of the transparent display. Both TFT-LCD and OLED provide good image quality, but each type of the transparent display has its own defect. For TFT-LCD type transparent display, there is no white pixel due to the white pixel is transparent. Relatively, for OLED type transparent display, there is no black pixel due to the black pixel is transparent. Further, due to the transparency of the display panel, contrast and visibility of images are somewhat low for the user. Thereby, how to improve contrast and visibility of images and achieve an optimal image quality for transparent display panel is one of the major subjects in the industry. A patent application US 2007/216987 A1 discloses useful information for understanding the background of the invention.

### SUMMARY OF THE DISCLOSURE

The disclosure is directed to a display apparatus, in which a shutter unit is employed for switching and providing backgrounds, so as to improve contrast and visibility of images and to achieve an optimal image quality.

The disclosure is also directed to an image forming method, in which a shutter unit is moved to different positions for switching and providing backgrounds, so as to improve contrast and visibility of images and to achieve an optimal image quality.

An embodiment of the disclosure provides a display apparatus. The display apparatus includes a transparent display layer and a light modification layer. The transparent display layer includes a plurality of pixel units for displaying images. The light modification is disposed under the transparent display layer and includes a substrate body having a plurality of first apertures and a plurality of shutter units disposed above the substrate body. Further, the plurality of the shutter units is between the plurality of the pixel units and the plurality of the first apertures. When at least one of the shutter units is moved to a first position and misaligns with at least one of the first apertures, an ambient light transmits through the shutter unit and is reflected by the substrate body. When at least one of the shutter units is moved to a second position and aligns with the at least one of the first aperture, the ambient light transmits through the shutter unit and the at least one of the first apertures.

An embodiment of the disclosure provides a method of forming an image on a display apparatus having a transparent display layer and a light modification layer. The transparent display layer includes a plurality of pixel units, and the light modification layer is disposed under the transparent display layer and includes a substrate body having a plurality of first apertures and a plurality of shutter units disposed above the substrate body. The method includes the following steps. At least one of the plurality of pixel units is driven to display images. When the at least one of the plurality of pixel units is driven, at least one of the plurality of the shutter units corresponding to the driven pixel unit is moved to a first position, and an ambient light transmits through the shutter unit and is reflected by the substrate body. When at least one of the plurality of pixel units is not driven, at least one of the plurality of shutter units corresponding to the undriven pixel unit is moved to the first position so that the ambient light transmits through the shutter unit and is reflected by the substrate body or a second position so that the ambient light transmits through the shutter unit and the substrate body.

As described above, in the display apparatus provided by the present disclosure, the shutter units are respectively controlled for adjusting the ambient light, and the substrate body can be employed as a background by controlling the shutter unit for the display apparatus while displaying images. Thus, the display apparatus is configured to improve contrast and visibility of images and to achieve an optimal image quality. Moreover, when the display apparatus is disabled, the light modification layer can also be configured to allow the ambient light to pass, so as to maintain the transparency of the display apparatus. The method for forming an image provided by the present disclosure using the shutter units for adjusting the ambient light.

These and other exemplary embodiments, features, aspects, and advantages of the disclosure will be described and become more apparent from the detailed descriptions of exemplary embodiments when read in conjunction with accompanying drawings.

### BRIEF DESCRIPTION OF THE DRAWINGS

The accompanying drawings are included to provide a further understanding of the disclosure, and are incorporated in and constitute a part of this specification. The drawings illustrate exemplary embodiments of the disclosure and, together with the description, serve to explain the principles of the disclosure.
FIG. 1 is an exploded diagram of a display apparatus according to an embodiment of the disclosure.
FIG. 2A is a schematic diagram of moving the shutter unit to a first position according to an embodiment of the disclosure.
FIG. 2B is a schematic diagram of moving the shutter unit to a second position according to an embodiment of the disclosure.
FIG. 3A and 3B are top views of a shutter unit according to an embodiment of the present disclosure.
FIG. 4 a schematic diagram of a display apparatus according to an embodiment of the present disclosure.
FIG. 5 a schematic diagram of a display apparatus according to another embodiment of the present disclosure.
FIG. 6 is a flowchart of a method of forming an image on a display apparatus.

### DESCRIPTION OF THE EMBODIMENTS

Reference will now be made in detail to the present preferred embodiments of the disclosure, examples of which are illustrated in the accompanying drawings. Wherever possible, the same reference numbers are used in the drawings and the description to refer to the same or like parts.

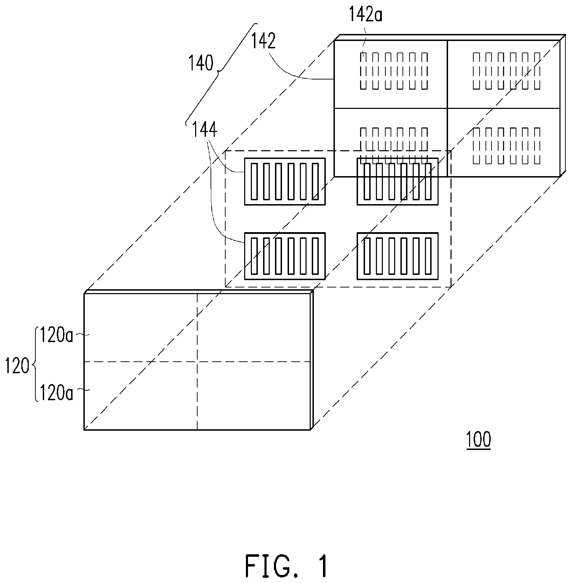

FIG. 1 is an exploded diagram of a display apparatus according to an embodiment of the disclosure. Referring to FIG. 1, the display apparatus 100 includes a transparent display layer 120 and a light modification layer 140. The transparent display layer 120 includes a plurality of pixel units 120a for displaying an image. The light modification layer 140 is disposed under the transparent display layer 120 and includes a substrate body 142 having a plurality of first apertures 142a and a plurality of shutter units 144 disposed above the substrate body 142. The plurality of the shutter units 144 is disposed between the plurality of pixel units 120a and the plurality of the first apertures 142a. In FIG. 1, each of the shutter units 144 is respectively disposed between one pixel unit 120a and at least one of the first apertures 140a. However, in another embodiment, more than one shutter unit can also be disposed between one pixel unit and at least one of the first apertures. Further, in another embodiment, each of the pixel units can include a plurality of sub-pixel units, and each of the sub-pixel units is corresponding to the plurality of shutter units and the plurality of the first apertures.

The shutter units 144 are movable. By respectively controlling and moving the shutter units 144, the ambient lights transmitting through the transparent display layer 120 and the shutter units 144 are respectively reflected by the substrate body 142 or respectively transmit through the first apertures 142a. The detailed description of controlling the shutter units 144 is provided with diagrams below.

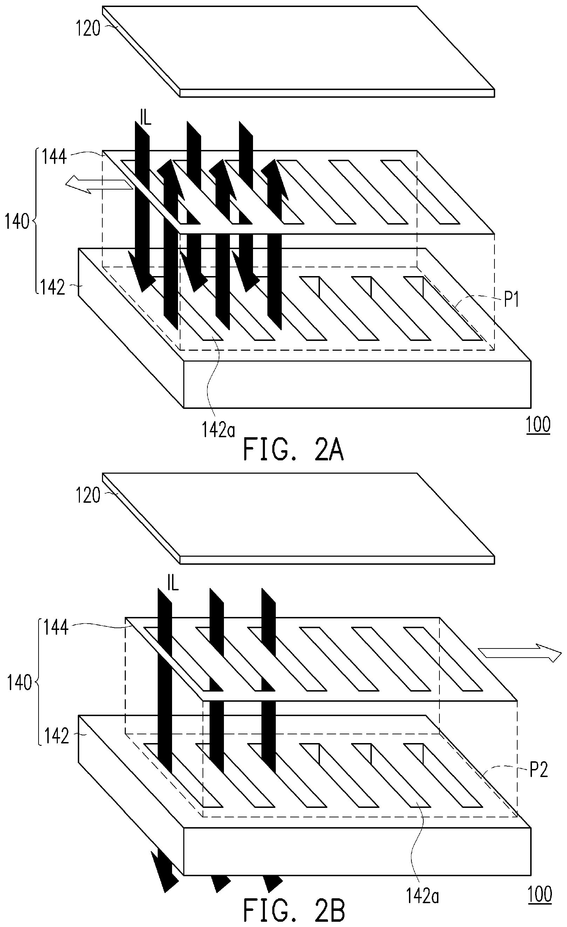

FIG. 2A is a schematic diagram of moving the shutter unit to a first position according to an embodiment of the disclosure. To simplify the diagram, only one shutter unit 144 is shown in the diagram. Referring to FIG. 2A, when at least one of the shutter units 144 is moved to a first position P1 and misaligns with the at least one of the first aperture 142a, the ambient light transmits through the shutter unit 144 and is reflected by the substrate body 142. To be more specific, only a portion of the shutter unit 144 allows the ambient light to pass through it. Therefore, when the shutter unit 144 is misaligned with the first apertures 142a, the ambient light transmitting through the shutter unit 144 is projected to the substrate body 142 and is reflected back to the transparent display layer 120. That is to say, the light modification layer 140 is configured to reflect the ambient light by the substrate body 142, and the substrate body 142 is employed as a background.

On the other hand, the light modification layer 140 can also be configured to allow the ambient light to pass. FIG. 2B is a schematic diagram of moving the shutter unit to a second position according to an embodiment of the disclosure. As same as FIG. 2A, only one shutter unit 144 is shown in FIG. 2B. Referring to FIG. 2B, when the at least one of the shutter units 144 is moved to a second position P2 and aligns with the at least one of the first aperture 142a, the ambient light transmits through the shutter unit 144 and the at least one of the first apertures 142a. Since the shutter unit 144 is aligned with the at least one of the first apertures 142a, the ambient light is capable of transmitting through the light modification layer 140. As the result, the pixel unit corresponding to the shutter unit 144 and the first apertures 142a shown in FIG. 2B is regarded as a transparent pixel unit.

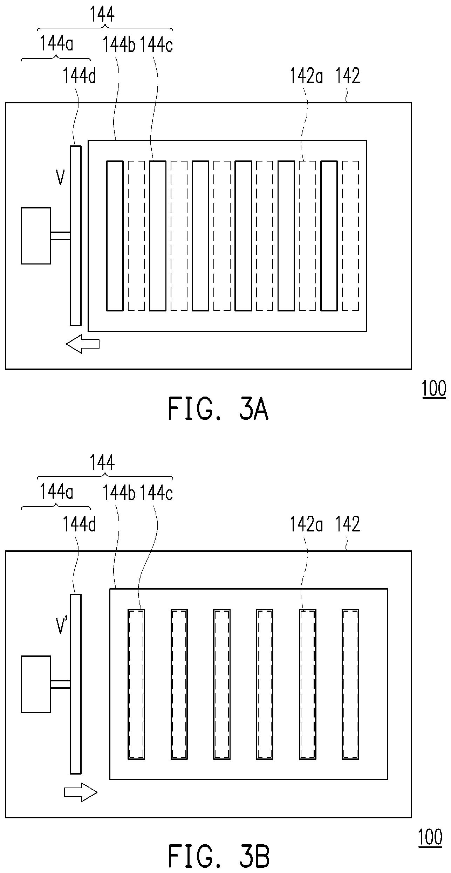

FIG. 3A and 3B are top views of a shutter unit according to an embodiment of the present disclosure. Referring to FIG. 3A, the shutter unit 144 includes at least one actuator 144a and a shutter 144b having at least one second aperture 144c and coupled to the actuator 144a. The actuator 144a moves the shutter 144b to the first position P1 or the second position P2 transversely over a surface of the substrate body in plane of motion which is parallel to the surface of the substrate body 142 (as shown in FIG. 2A and 2B). In this embodiment, when the shutter 144b is moved to the second position P2, the second apertures 144c are aligned with the first apertures 142a as shown in FIG. 3B, and the ambient light is capable of transmitting through the substrate body 142 through the first aperture 142a and the second aperture 144c. By contrast, when the shutter 144b is moved to the first position P1, the first apertures 144c are misaligned with the second apertures 142a as shown in FIG. 3A, and the ambient light transmits through the shutter unit 144 and reaches the substrate body 142.

Referring to FIG. 3A and 3B, the shutter 144b can be moved towards or away from the actuator 144a by magnetic force or electrostatic force. In the present embodiment, the actuator 144a includes a drive electrode 144d. When an electric potential V is applied to the drive electrode 144d, the shutter 144b is electrostatically drawn towards the drive electrode 144d. According to the present embodiment, when the shutter 144b is drawn towards the actuator 144a, the second apertures 144c are misaligned with the first apertures 142a. That is to say, the shutter 144b is moved to the first position. As the result, the ambient light transmitting through the shutter 144b will be reflected by the substrate body 142. Obviously, when an opposite electric potential V' shown in FIG. 3B is applied to the drive electrode 144d, the shutter 144b is electrostatically moved away from the actuator 144a. Therefore, the second apertures 144c are aligned with the first apertures 142a, and the ambient light is capable of transmitting through the shutter unit 144 and the substrate body 142.

The present disclosure is not limited to the embodiment shown above, and the shutter unit 144 can be designed with different patterns. For example, a load electrode (not shown) coupled to the shutter 144b can be disposed between the drive electrode 144d and the shutter 144b. Both of the drive electrode 144d and the load electrode are made by flexible material. When the electric potential V is applied to the drive electrode 144d, the load electrode is thus attracted by the drive electrode 144d, so as to pull the shutter 144b towards the actuator 144a. Further, another actuator (not shown) can be disposed opposite to the actuator 144a. By using more than one actuator, movement of the shutter 144b can be precisely controlled.

In the previous description, the substrate body 142 is adopted as the background while the shutter unit 144 is moved to the first position P1. However, the present disclosure is not limited herein, and a first layer disposed on the substrate body 142 for light modulation is proposed.

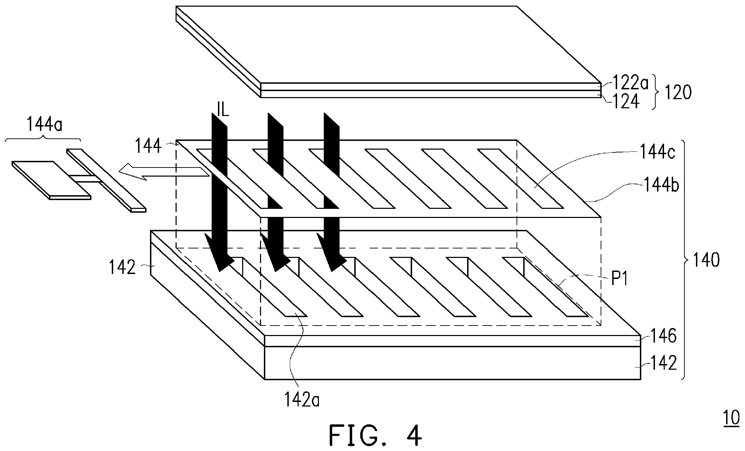

FIG. 4 a schematic diagram of a display apparatus according to an embodiment of the present disclosure. Referring to FIG. 4, the substrate body 142 further includes a first layer 146 disposed on the substrate body 142. In other words, the fist layer 146 is disposed between the substrate body 142 and the shutter unit 144. The first layer 146 partially or fully covers the substrate body 142. Further, the transparent display layer 120 includes an organic light emitting diode (OLED) layer 122a and a thin film transistor (TFT) layer 124 configured to drive the OLED layer 122a for displaying images. Both the OLED layer 122a and the TFT layer 124 are transparent. In the present embodiments, when the ambient light transmits to the first layer 146, the ambient light is absorbed. By contrast, when the ambient light is incident on the first apertures 142a, the ambient light transmits through the substrate body 142. To be more specific, the first layer 146 can be a black color coating layer for light absorbing in this embodiment. The first layer 146 is suitable for use with the OLED layer 122a because the transparent display layer 120 using the OLED layer 122a is lack of black pixels.

To simplify the diagram, only one shutter unit 144 is shown in FIG. 4. When at least one of the pixel units 120a (shown in FIG. 1) is driven for displaying an image, at least one of shutter 144b corresponding to the pixel units 120a is moved to the first position P1 to misalign the second apertures 144c with at least one of first apertures 142a. Therefore, the ambient light transmitting through the transparent display layer 120 is absorbed by the first layer 146, so as to improve the contrast and the visibility of images. On the other hand, when at least one of the pixel units is not driven and in the idle state, at least one of shutter 144b corresponding to the pixel unit is moved to the second position to align the second apertures 144c of the shutter 144b with at least one of the first apertures 142a. Although FIG. 4 does not illustrate the shutter 144b which is moved to the second position P2, it still can be inferred from FIG. 2B. As the result, the ambient light is capable of transmitting through the light modification layer 140, so as to maintain the transparency of the pixel units 120a. In other words, the corresponding pixel unit 120a is the transparent pixel. The shutter 144b can be moved by the actuator 144a or other devices in order to reach the effect of the light modulation.

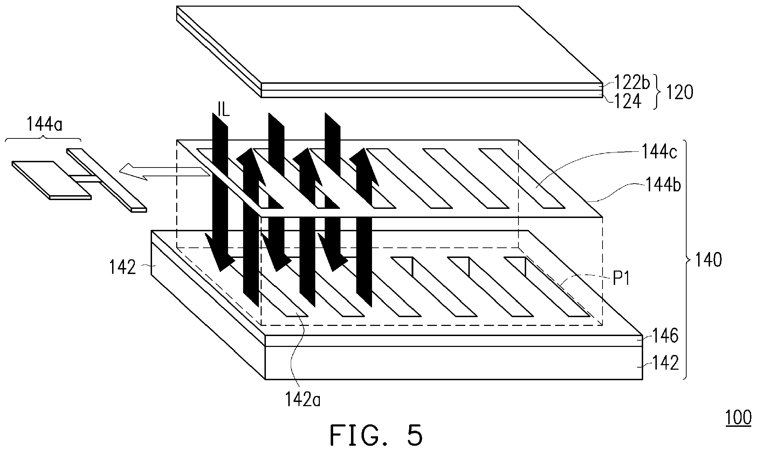

FIG. 5 a schematic diagram of a display apparatus according to another embodiment of the present disclosure. Referring to FIG. 5, the substrate body 142 further includes a first layer 146 disposed on the substrate body 142. The first layer 146 partially or fully covers the substrate body 142. The transparent display layer 120 includes a liquid crystal (LC) layer 122b and a thin film transistor (TFT) layer 124 configured to drive the LC layer 122b for displaying images. Both the LC layer 122b and the TFT layer 124 are transparent. In this embodiment, when the ambient light transmits to the first layer 146, the ambient light IL is reflected by the first layer 146, and when the ambient light reaches the first apertures 142a, the ambient light transmits through the substrate body 142. To be more specific, the first layer 146 can be a white color coating layer for light reflecting in this embodiment. The first layer 146 is suitable for use with the LC layer 122b because the transparent display layer 120 using the LC layer 122b and the TFT layer 124 is lack of white pixels.

Similar to FIG. 4, only one shutter unit 144 is shown in FIG. 5. When at least one of the pixel units 120a (shown in FIG. 1) is driven for displaying an image, at least one of the shutters 144b corresponding to the pixel units 120a is moved to the first position P1 to misalign the second apertures 144c with at least one of first apertures 142a. Therefore, the ambient light transmitting through the transparent display layer 120 is reflected by the first layer 146, so as to improve the contrast and the visibility of images. On the other hand, when at least one of the pixel units is not driven and in the idle state, at least one of shutter 144b corresponding to the pixel unit is moved to the second position to align the second apertures 144c of the shutter 144b with at least one of the first apertures 142a. Although FIG. 5 does not illustrate the shutter 144b which is moved to the second position P2, it still can be inferred from FIG. 2B. As the result, the ambient light is capable of transmitting through the light modification layer 140, so as to maintain the transparency of the pixel units 120a.

Based on the above description, the first layer 146 is chosen according to the type of the display using in the transparent display layer 120. However, the first layer 146 can also be chosen for additional function of the display apparatus 100. Referring to the structure of the light modification layer 140 shown in FIG. 4 and 5 as an example, in one embodiment of the present disclosure, the first layer 146 is a metallic layer. When the ambient light transmits to the metallic layer, the ambient light is reflected, and when the ambient light reaches the first apertures 142a, the ambient light transmits through the substrate body 142. The display apparatus 100 in this embodiment is further applied as a mirror when the pixel units 120a (shown in FIG. 1) are not driven for displaying images. To be more specific, when at least one of the pixel units 120a is not driven, at least one of the shutters 144b corresponding to the pixel units 120a is moved to the first position P1 to misalign the second apertures 144c of the shutter 144b with at least one of the first apertures 142a. That is to say, when the transparent display layer 120 is in idle state without displaying images, by moving the shutters 144b to the first position P1, the display apparatus 100 can be configured to be a mirror.

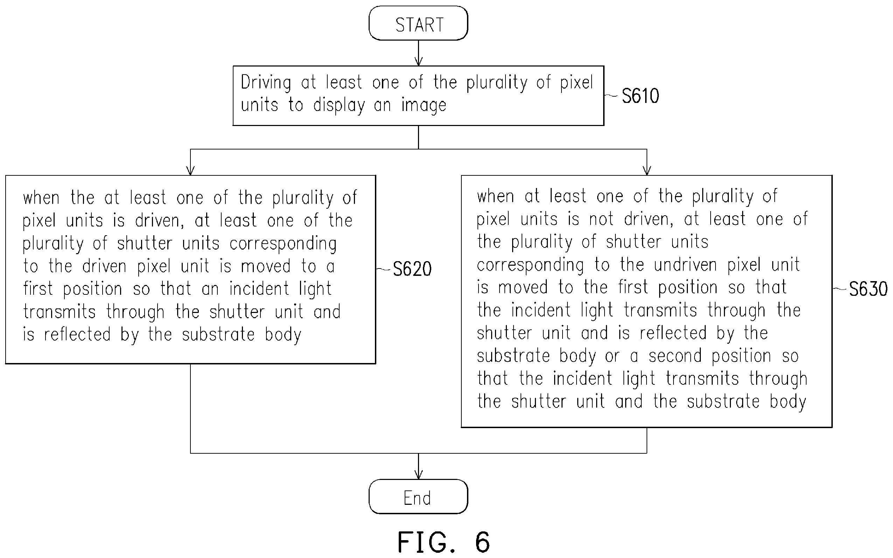

FIG. 6 is a flowchart of a method of forming an image on a display apparatus. In the present disclosure, a method for forming an image on a display apparatus is also provided. The display apparatus includes a plurality of pixel units and a light modification layer disposed under the transparent display layer. The light modification layer further includes a substrate body having a plurality of first apertures and a plurality of shutter units disposed above the substrate body. The method includes the following steps. In step S610, at least one of the plurality of pixel units is driven to display an image. In step S620, when the at least one of the plurality of pixel units is driven, at least one of the plurality of shutter units corresponding to the driven pixel unit is moved to a first position so that the shutter unit misaligns with at least one first aperture, and an ambient light transmits through the shutter unit and is reflected by the substrate body. That is to say, the substrate body is used as a back ground for the driven pixel units. However, a portion of the pixel units may be undriven. In step S630, when at least one of the plurality of pixel units is not driven, at least one of the plurality of shutter units corresponding to the undriven pixel is moved to the first position so that the ambient light transmits through the shutter unit and is reflected by the substrate body or moved to a second position so that the ambient light transmits through the shutter unit and the substrate body. To be more specific, when the shutter unit is moved to the first position, the shutter unit misaligns with at least one of the first apertures, and when the shutter unit is moved to the second position, the shutter unit aligns with the at least one of the first apertures. As the result, the position of the shutter unit is the key for determining whether the ambient light transmits through the substrate body.

Based on the above description, when the pixel unit is undriven, the shutter unit is moved to the second position so that the ambient light transmits through the shutter unit and the substrate body, so as to maintain the transparency of the pixel unit. However, the shutter unit can be moved to the first position as well even when the corresponding pixel unit is undriven. Under such condition, all the pixel units are over the same background, so as to bring a consistent visual effect.

As described above, the shutter units are employed by the display apparatus for light modification. To be more specific, the shutter units are respectively moved to the first position or the second position according to the corresponding pixel units. When the shutter unit is moved to the first position, the ambient light transmitting through the shutter unit is reflected by the substrate body, and the substrate body is thus applied as the background. Therefore, the contrast and the visibility of images can be improved. By contrast, when the shutter unit is moved to the second position, the ambient light transmits through the light modification layer, so as to maintain the transparency of the corresponding pixel unit. Moreover, a first layer disposed on the substrate body can be further applied for various light modification effect. A method for forming an image using the display apparatus described above is also mentioned above.

It will be apparent to those skilled in the art that various modifications and variations can be made to the structure of the disclosure without departing from the scope of the disclosure. In view of the foregoing, it is intended that the disclosure cover modifications and variations of this invention provided they fall within the scope of the appended claims.

## Claims

1. A display apparatus, comprising:
a transparent display layer (120), disposed in the top of the display apparatus, comprising a plurality of pixel units (120a) for displaying an image, and the transparent display layer (120) further comprising an organic light emitting diode, OLED, layer or a liquid crystal, LC, layer, and a thin film transistor, TFT, layer, wherein the TFT is configured to drive the OLED layer or the LC layer for displaying the images, and wherein the OLED, the LC layer and the TFT layer are transparent; and
a light modification layer (140) comprising a substrate body (142), which has a plurality of first apertures (142a), and a plurality of shutter units (144);
wherein the plurality of shutter units (144) is disposed between the transparent display layer (120) and the substrate body (142) respectively, and the plurality of shutter units (144) is disposed between the plurality of pixel units (120a) and the plurality of first apertures (142a) respectively; and
wherein when at least one of the shutter units (144) is moved to a first position, P1, and misaligns with at least one of the first apertures (142a), an ambient light transmits through the shutter unit (144) and is reflected by the substrate body (142) and when the at least one of the shutter units (144) is moved to a second position, P2, and aligns with the at least one of the first apertures (142a), the ambient light transmits through the shutter unit (144) and the at least one of the first apertures (142a).

2. The display apparatus as claimed in claim 1, wherein each of the pixel units (120a) comprises a plurality of sub-pixel units.

3. The display apparatus as claimed in any one of claims 1 to 2, wherein the shutter unit (144) comprises at least one actuator (144a), and a shutter (144b) having at least one second aperture (144c) and coupled to the at least one actuator (144a), wherein the at least one actuator (144a) moves the shutter (144b) to the first position, P1, or the second position, P2, transversely over a surface of the substrate body (142) in plane of motion which is parallel to the surface of the substrate body (142).

4. The display apparatus as claimed in claim 3, wherein when the shutter (144b) is moved to the second position, P2, to align the at least one second aperture (144c) with the at least one of first apertures (142a), the incident light transmits through the substrate body (142) through the first aperture (142a) and the second aperture (144c).

5. The display apparatus as claimed in any one of claims 3 to 4, wherein the actuator (144a) comprises a drive electrode (144d) and when an electric potential, V, is applied to the drive electrode (144d), the shutter (144b) is electrostatically drawn towards the drive electrode (144d).

6. The display apparatus as claimed in any one of claims 1 to 5, wherein the substrate body (142) further comprises a first layer (146) disposed on the substrate body (142) and when the ambient light transmits to the first layer (146), the ambient light is absorbed and when the ambient light is incident on the first aperture (142a), the ambient light transmits through the substrate body (142).

7. The display apparatus as claimed in any one of claims 1 to 6, wherein the substrate body (142) further comprises a first layer (146) disposed on the substrate body (142) and when the ambient light transmits to the first layer (146), the ambient light is reflected and when the ambient light reaches the first aperture (142a), the ambient light transmits through the substrate body (142).

8. The display apparatus as claimed in any one of claims 1 to 7, wherein the first layer (146) is a metallic layer and when the ambient light transmits to the metallic layer, the ambient light is reflected and when the ambient light reaches the first aperture (142a), the ambient light transmits through the substrate body (142).

9. The display apparatus as claimed in any one of claims 3 to 8, wherein the shutter (144b is configured to be moved to the first position, P1, to misalign the at least one of the first apertures (142a) with the at least one second aperture (144c), for transmitting the ambient light through the shutter unit (144) and for reaching the substrate body (142).

10. The display apparatus as claimed in any one of claim 3 to 9, wherein when at least one of the pixel units (120a) is driven for displaying an image, at least one of the shutters (144b) corresponding to the pixel unit (120a) is configured to be moved to the first position, P1, to misalign the at least one second aperture (144c) of the shutter (144b) with the at least one of the first apertures (142a).

11. The display apparatus as claimed in any one of claims 3 to 10, wherein when at least one of the pixel units (120a) is not driven, at least one of the shutters (144b) corresponding to the pixel units (120a) is configured to be moved to the first position, P1, to misalign the at least one second aperture (144c) of the shutter (144b) with the at least one of the first apertures (142a).

12. The display apparatus as claimed in any one of claims 3 to 11, wherein when at least one of the pixel units (120a) is not driven, at least one of the shutters (144b) corresponding to the pixel units (120a) is configured to be moved to the second position, P2, to align the at least one second aperture (144c) of the shutter (144b) with the at least one of the first apertures (142a).

13. A method of forming an image on a display apparatus having a transparent display layer comprising a plurality of pixel units; and the transparent display layer (120) further comprising an organic light emitting diode, OLED, layer or a liquid crystal, LC, layer, and a thin film transistor, TFT, layer, wherein the TFT is configured to drive the OLED layer or the LC layer for displaying the images, and wherein the OLED, the LC layer and the TFT layer are transparent; and a light modification layer comprising a substrate body, which has a plurality of first apertures and a plurality of shutter units;
wherein the plurality of shutter units is disposed between the transparent display layer and the substrate body respectively, the method comprising:
- driving (S610) at least one of the plurality of pixel units to display an image;
wherein (S620) when the at least one of the plurality of pixel units is driven, at least one of the plurality of shutter units corresponding to the driven pixel unit is moved to a first position, and an ambient light transmits through the shutter unit and is reflected by the substrate body; and
wherein (S630) when at least one of the plurality of pixel units is not driven, at least one of the plurality of shutter units corresponding to the undriven pixel unit is moved to the first position so that the ambient light transmits through the shutter unit and is reflected by the substrate body or a second position so that the ambient light transmits through the shutter unit and the substrate body.

## Patentansprüche

1. Eine Anzeigevorrichtung, beinhaltend:
eine transparente Anzeigeschicht (120), die in der oberen Seite der Anzeigevorrichtung angeordnet ist, beinhaltend eine Vielzahl von Pixeleinheiten (120a) zum Anzeigen eines Bilds, und wobei die transparente Anzeigeschicht (120) ferner eine organische Leuchtdiodenschicht, OLED-Schicht, oder eine Flüssigkristallschicht, LC-Schicht, und eine Dünnschichttransistorschicht, TFT-Schicht, beinhaltet, wobei der TFT konfiguriert ist, die OLED-Schicht oder die LC-Schicht zum Anzeigen der Bilder anzutreiben, und wobei die OLED, die LC-Schicht und die TFT-Schicht transparent sind; und
eine Lichtmodifikationsschicht (140), beinhaltend einen Substratkörper (142), welcher eine Vielzahl von ersten Öffnungen (142a) und eine Vielzahl von Verschlusseinheiten (144) aufweist;
wobei die Vielzahl von Verschlusseinheiten (144) jeweils zwischen der transparenten Anzeigeschicht (120) und dem Substratkörper (142) angeordnet ist und die Vielzahl von Verschlusseinheiten (144) jeweils zwischen der Vielzahl von Pixeleinheiten (120a) und der Vielzahl von ersten Öffnungen (142a) angeordnet ist; und
wobei, wenn mindestens eine der Verschlusseinheiten (144) in eine erste Position P1 bewegt wird und von mindestens einer von den ersten Öffnungen (142a) versetzt ist, ein Umgebungslicht durch die Verschlusseinheit (144) fällt und von dem Substratkörper (142) reflektiert wird, und wenn die mindestens eine der Verschlusseinheiten (144) in eine zweite Position P2 bewegt wird und nach der mindestens einen der ersten Öffnungen (142a) ausgerichtet ist, das Umgebungslicht durch die Verschlusseinheit (144) und die mindestens eine der ersten Öffnungen (142a) fällt.

2. Anzeigevorrichtung gemäß Anspruch 1, wobei jede der Pixeleinheiten (120a) eine Vielzahl von Unterpixeleinheiten beinhaltet.

3. Anzeigevorrichtung gemäß einem der Ansprüche 1 bis 2, wobei die Verschlusseinheit (144) mindestens einen Aktuator (144a) und einen Verschluss (144b), der mindestens eine zweite Öffnung (144c) aufweist und an den mindestens einen Aktuator (144a) gekoppelt ist, beinhaltet, wobei der mindestens eine Aktuator (144a) den Verschluss (144b) in einer zu der Oberfläche des Substratkörpers (142) parallelen Bewegungsebene quer über eine Oberfläche des Substratkörpers (142) in die erste Position P1 oder die zweite Position P2 bewegt.

4. Anzeigevorrichtung gemäß Anspruch 3, wobei, wenn der Verschluss (144b) in die zweite Position P2 bewegt wird, um die mindestens eine zweite Öffnung (144c) nach der mindestens einen der ersten Öffnungen (142a) auszurichten, das einfallende Licht durch die erste Öffnung (142a) und die zweite Öffnung (144c) durch den Substratkörper (142) fällt.

5. Anzeigevorrichtung gemäß einem der Ansprüche 3 bis 4, wobei der Aktuator (144a) eine Antriebselektrode (144d) beinhaltet und wenn ein elektrisches Potential V an die Antriebselektrode (144d) angelegt wird, der Verschluss (144b) elektrostatisch zu der Antriebselektrode (144d) hin gezogen wird.

6. Anzeigevorrichtung gemäß einem der Ansprüche 1 bis 5, wobei der Substratkörper (142) ferner eine auf dem Substratkörper (142) angeordnete erste Schicht (146) beinhaltet und wenn das Umgebungslicht auf die erste Schicht (146) fällt, das Umgebungslicht absorbiert wird, und wenn das Umgebungslicht auf die erste Öffnung (142a) einfällt, das Umgebungslicht durch den Substratkörper (142) fällt.

7. Anzeigevorrichtung gemäß einem der Ansprüche 1 bis 6, wobei der Substratkörper (142) ferner eine auf dem Substratkörper (142) angeordnete erste Schicht (146) beinhaltet und wenn das Umgebungslicht auf die erste Schicht (146) fällt, das Umgebungslicht reflektiert wird, und wenn das Umgebungslicht die erste Öffnung (142a) erreicht, das Umgebungslicht durch den Substratkörper (142) fällt.

8. Anzeigevorrichtung gemäß einem der Ansprüche 1 bis 7, wobei die erste Schicht (146) eine metallische Schicht ist und wenn das Umgebungslicht auf die metallische Schicht fällt, das Umgebungslicht reflektiert wird, und wenn das Umgebungslicht die erste Öffnung (142a) erreicht, das Umgebungslicht durch den Substratkörper (142) fällt.

9. Anzeigevorrichtung gemäß einem der Ansprüche 3 bis 8, wobei der Verschluss (144b) konfiguriert ist, um in die erste Position P1 bewegt zu werden, um die mindestens eine der ersten Öffnungen (142a) von der mindestens einen zweiten Öffnung (144c) zu versetzen, damit das Umgebungslicht durch die Verschlusseinheit (144) fällt und den Substratkörper (142) erreicht.

10. Anzeigevorrichtung gemäß einem der Ansprüche 3 bis 9, wobei, wenn mindestens eine der Pixeleinheiten (120a) zum Anzeigen eines Bilds angetrieben wird, mindestens einer der der Pixeleinheit (120a) entsprechenden Verschlüsse (144b) konfiguriert ist, in die erste Position P1 bewegt zu werden, um die mindestens eine zweite Öffnung (144c) des Verschlusses (144b) von der mindestens einen der ersten Öffnungen (142a) zu versetzen.

11. Anzeigevorrichtung gemäß einem der Ansprüche 3 bis 10, wobei, wenn mindestens eine der Pixeleinheiten (120a) nicht angetrieben wird, mindestens einer der den Pixeleinheiten (120a) entsprechenden Verschlüsse (144b) konfiguriert ist, in die erste Position P1 bewegt zu werden, um die mindestens eine zweite Öffnung (144c) des Verschlusses (144b) von der mindestens einen der ersten Öffnungen (142a) zu versetzen.

12. Anzeigevorrichtung gemäß einem der Ansprüche 3 bis 11, wobei, wenn mindestens eine der Pixeleinheiten (120a) nicht angetrieben wird, mindestens einer der den Pixeleinheiten (120a) entsprechenden Verschlüsse (144b) konfiguriert ist, in die zweite Position P2 bewegt zu werden, um die mindestens eine zweite Öffnung (144c) des Verschlusses (144b) nach der mindestens einen der ersten Öffnungen (142a) auszurichten.

13. Ein Verfahren zum Erzeugen eines Bilds auf einer Anzeigevorrichtung mit einer transparenten Anzeigeschicht, die eine Vielzahl von Pixeleinheiten beinhaltet; und wobei die transparente Anzeigeschicht (120) ferner eine organische Leuchtdiodenschicht, OLED-Schicht, oder eine Flüssigkristallschicht, LC-Schicht, und eine Dünnschichttransistorschicht, TFT-Schicht, beinhaltet, wobei der TFT konfiguriert ist, die OLED-Schicht oder die LC-Schicht zum Anzeigen der Bilder anzutreiben, und wobei die OLED, die LC-Schicht und die TFT-Schicht transparent sind; und einer Lichtmodifikationsschicht, beinhaltend einen Substratkörper, welcher eine Vielzahl von ersten Öffnungen und eine Vielzahl von Verschlusseinheiten aufweist;
wobei die Vielzahl von Verschlusseinheiten jeweils zwischen der transparenten Anzeigeschicht und dem Substratkörper angeordnet ist, wobei das Verfahren Folgendes beinhaltet:
- Antreiben (S610) mindestens einer der Vielzahl von Pixeleinheiten, um ein Bild anzuzeigen;
wobei (S620), wenn die mindestens eine der Vielzahl von Pixeleinheiten angetrieben wird, mindestens eine der der angetriebenen Pixeleinheit entsprechenden Vielzahl von Verschlusseinheiten in eine erste Position bewegt wird und ein Umgebungslicht durch die Verschlusseinheit fällt und von dem Substratkörper reflektiert wird; und
wobei (S630), wenn mindestens eine der Vielzahl von Pixeleinheiten nicht angetrieben wird, mindestens eine der der nicht angetriebenen Pixeleinheit entsprechenden Vielzahl von Verschlusseinheiten in die erste Position bewegt wird, so dass das Umgebungslicht durch die Verschlusseinheit fällt und von dem Substratkörper reflektiert wird, oder in eine zweite Position bewegt wird, so dass das Umgebungslicht durch die Verschlusseinheit und den Substratkörper fällt.

## Revendications

1. Un appareil d'affichage, comprenant :
une couche d'affichage transparente (120), disposée dans le haut de l'appareil d'affichage, comprenant une pluralité d'unités de pixel (120a) destinées à afficher une image, et la couche d'affichage transparente (120) comprenant en outre une couche de diode électroluminescente organique, DELO, ou une couche de cristaux liquides, CL, et une couche de transistor à films minces, TFT, dans lequel le TFT est configuré pour entraîner la couche de DELO ou la couche de CL destinée à afficher les images, et dans lequel la DELO, la couche CL et la couche TFT sont transparentes ; et
une couche de modification de lumière (140) comprenant un corps de substrat (142), lequel a une pluralité de premières ouvertures (142a), et une pluralité d'unités formant obturateurs (144) ;
dans lequel la pluralité d'unités formant obturateurs (144) est disposée entre la couche d'affichage transparente (120) et le corps de substrat (142) respectivement, et la pluralité d'unités formant obturateurs (144) est disposée entre la pluralité d'unités de pixel (120a) et la pluralité de premières ouvertures (142a) respectivement ; et
dans lequel lorsqu'au moins une des unités formant obturateurs (144) est déplacée jusqu'à une première position, P1, et fait un mauvais alignement avec au moins une des premières ouvertures (142a), une lumière ambiante se transmet à travers l'unité formant obturateur (144) et est réfléchie par le corps de substrat (142) et lorsque l'au moins une unité des unités formant obturateurs (144) est déplacée jusqu'à une deuxième position, P2, et est en alignement avec l'au moins une ouverture des premières ouvertures (142a), la lumière ambiante se transmet à travers l'unité formant obturateur (144) et l'au moins une ouverture des premières ouvertures (142a).

2. L'appareil d'affichage tel que revendiqué dans la revendication 1, dans lequel chacune des unités de pixel (120a) comprend une pluralité d'unités de sous-pixel.

3. L'appareil d'affichage tel que revendiqué dans n'importe laquelle des revendications 1 à 2, dans lequel l'unité formant obturateur (144) comprend au moins un actionneur (144a), et un obturateur (144b) ayant au moins une deuxième ouverture (144c) et couplé à l'au moins un actionneur (144a), dans lequel l'au moins un actionneur (144a) déplace l'obturateur (144b) jusqu'à la première position, P1, ou la deuxième position, P2, transversalement par-dessus une surface du corps de substrat (142) dans un plan de mouvement qui est parallèle à la surface du corps de substrat (142).

4. L'appareil d'affichage tel que revendiqué dans la revendication 3, dans lequel lorsque l'obturateur (144b) est déplacé jusqu'à la deuxième position, P2, pour mettre en alignement l'au moins une deuxième ouverture (144c) avec l'au moins une ouverture des premières ouvertures (142a), la lumière incidente se transmet à travers le corps de substrat (142) à travers la première ouverture (142a) et la deuxième ouverture (144c).

5. L'appareil d'affichage tel que revendiqué dans n'importe laquelle des revendications 3 à 4, dans lequel l'actionneur (144a) comprend une électrode d'entraînement (144d) et lorsqu'un potentiel électrique, V, est appliqué sur l'électrode d'entraînement (144d), l'obturateur (144b) est amené électrostatiquement vers l'électrode d'entraînement (144d).

6. L'appareil d'affichage tel que revendiqué dans n'importe laquelle des revendications 1 à 5, dans lequel le corps de substrat (142) comprend en outre une première couche (146) disposée sur le corps de substrat (142) et lorsque la lumière ambiante se transmet jusqu'à la première couche (146), la lumière ambiante est absorbée et lorsque la lumière ambiante est incidente sur la première ouverture (142a), la lumière ambiante se transmet à travers le corps de substrat (142).

7. L'appareil d'affichage tel que revendiqué dans n'importe laquelle des revendications 1 à 6, dans lequel le corps de substrat (142) comprend en outre une première couche (146) disposée sur le corps de substrat (142) et lorsque la lumière ambiante se transmet jusqu'à la première couche (146), la lumière ambiante est réfléchie et lorsque la lumière ambiante atteint la première ouverture (142a), la lumière ambiante se transmet à travers le corps de substrat (142).

8. L'appareil d'affichage tel que revendiqué dans n'importe laquelle des revendications 1 à 7, dans lequel la première couche (146) est une couche métallique et lorsque la lumière ambiante se transmet jusqu'à la couche métallique, la lumière ambiante est réfléchie et lorsque la lumière ambiante atteint la première ouverture (142a), la lumière ambiante se transmet à travers le corps de substrat (142).

9. L'appareil d'affichage tel que revendiqué dans n'importe laquelle des revendications 3 à 8, dans lequel l'obturateur (144b) est configuré pour être déplacé jusqu'à la première position, P1, pour mettre en mauvais alignement l'au moins une ouverture des premières ouvertures (142a) avec l'au moins une deuxième ouverture (144c), afin de transmettre la lumière ambiante à travers l'unité formant obturateur (144) et afin d'atteindre le corps de substrat (142).

10. L'appareil d'affichage tel que revendiqué dans n'importe laquelle des revendications 3 à 9, dans lequel lorsqu'au moins une des unités de pixel (120a) est entraînée afin d'afficher une image, au moins un des obturateurs (144b) correspondant à l'unité de pixel (120a) est configuré pour être déplacé jusqu'à la première position, P1, afin de mettre en mauvais alignement l'au moins une deuxième ouverture (144c) de l'obturateur (144b) avec l'au moins une ouverture des premières ouvertures (142a).

11. L'appareil d'affichage tel que revendiqué dans n'importe laquelle des revendications 3 à 10, dans lequel lorsqu'au moins une des unités de pixel (120a) n'est pas entraînée, au moins un des obturateurs (144b) correspondant aux unités de pixel (120a) est configuré pour être déplacé jusqu'à la première position, P1, afin de mettre en mauvais alignement l'au moins une deuxième ouverture (144c) de l'obturateur (144b) avec l'au moins une ouverture des premières ouvertures (142a).

12. L'appareil d'affichage tel que revendiqué dans n'importe laquelle des revendications 3 à 11, dans lequel lorsqu'au moins une des unités de pixel (120a) n'est pas entraînée, au moins un des obturateurs (144b) correspondant aux unités de pixel (120a) est configuré pour être déplacé jusqu'à la deuxième position, P2, pour mettre en alignement l'au moins une deuxième ouverture (144c) de l'obturateur (144b) avec l'au moins une ouverture des premières ouvertures (142a).

13. Une méthode pour former une image sur un appareil d'affichage ayant une couche d'affichage transparente comprenant une pluralité d'unités de pixel ; et la couche d'affichage transparente (120) comprenant en outre une couche de diode électroluminescente organique, DELO, ou une couche de cristaux liquides, CL, et une couche de transistor à films minces, TFT, dans laquelle le TFT est configuré pour entraîner la couche de DELO ou la couche de CL destinée à afficher les images, et dans laquelle la DELO, la couche CL et la couche TFT sont transparentes ; et une couche de modification de lumière comprenant un corps de substrat, lequel a une pluralité de premières ouvertures et une pluralité d'unités formant obturateurs ;
dans laquelle la pluralité d'unités formant obturateurs est disposée entre la couche d'affichage transparente et le corps de substrat respectivement, la méthode comprenant :
- le fait d'entraîner (S610) au moins une unité de pixel de la pluralité d'unités de pixel à afficher une image ;
dans laquelle (S620) lorsque l'au moins une unité de pixel de la pluralité d'unités de pixel est entraînée, au moins une unité formant obturateur de la pluralité d'unités formant obturateurs correspondant à l'unité de pixel entraînée est déplacée jusqu'à une première position, et une lumière ambiante se transmet à travers l'unité formant obturateur et est réfléchie par le corps de substrat ; et
dans laquelle (S630) lorsqu'au moins une unité de pixel de la pluralité d'unités de pixel n'est pas entraînée, au moins une unité formant obturateur de la pluralité d'unités formant obturateurs correspondant à l'unité de pixel non entraînée est déplacée jusqu'à la première position de sorte que la lumière ambiante se transmette à travers l'unité formant obturateur et soit réfléchie par le corps de substrat ou une deuxième position de sorte que la lumière ambiante se transmette à travers l'unité formant obturateur et le corps de substrat.
